(19) Europäisches Patentamt

European Patent Office

Office européen des brevets

(11) Veröffentlichungsnummer: **0 270 798 B1**

(12) **EUROPÄISCHE PATENTSCHRIFT**

(45) Veröffentlichungstag der Patentschrift: **15.07.92**

(21) Anmeldenummer: **87115682.4**

(22) Anmeldetag: **26.10.87**

(51) Int. Cl.⁵: **G01R 19/17**, G01R 19/04, G01R 29/033

(54) **Einrichtung zum selektiven Zählen von Signalen.**

(30) Priorität: **07.11.86 DE 3637942**

(43) Veröffentlichungstag der Anmeldung:
**15.06.88 Patentblatt 88/24**

(45) Bekanntmachung des Hinweises auf die
Patenterteilung:
**15.07.92 Patentblatt 92/29**

(84) Benannte Vertragsstaaten:
**BE CH DE ES FR GB IT LI NL**

(56) Entgegenhaltungen:
**EP-A- 0 181 239      DE-A- 2 436 656
DE-B- 1 082 939      FR-A- 2 295 429
GB-A- 2 110 363      US-A- 3 532 977
US-A- 3 896 375**

**RADIO FERNSEHEN ELEKTRONIK, Band 33,
Nr. 10, Oktober 1984, Seiten 667-668, Ost-
Berlin, DD; U. PROBST: "Analoger Extremwertmesser"**

**Idem**

(73) Patentinhaber: **SIEMENS AKTIENGESELL-
SCHAFT
Wittelsbacherplatz 2
W-8000 München 2(DE)**

(72) Erfinder: **Kerst, Bodo, Dipl.-Ing.
Bachstrasse 2
W-6072 Dreieich(DE)**

## Beschreibung

Die Erfindung betrifft eine Einrichtung zum selektiven Zählen von Signalen separiert nach ihrem Amplitudenmaximum, insbesondere von Signalen eines Kraftmeßbolzens, der mit einer Stoßbremse verbunden ist, zur Funktions- und Lebensdauerüberwachung der Stoßbremse, wobei ein Anschlußpunkt für das zu untersuchende Signal mit Diskriminatoren für verschiedene zunehmend höhere Amplitudenschwellwerte verbunden ist und wobei benachbarte Diskriminatoren jeweils mit einem Ex-Oder-Glied in Verbindung stehen, deren Ausgänge mit Zählern verbunden sind.

Ein Kraftmeßbolzen, der zur Bestimmung der Belastung von Stoßbremsen, die in Kernkraftwerken eingesetzt werden, geeignet ist, ist aus der DE-OS 34 29 805 bekannt. Dieser Kraftmeßbolzen gibt ein elektrisches Ausgangssignal ab, dessen Amplitude ein Maß für die Belastung der Stoßbremse ist. Parameter für die Lebensdauer einer Stoßbremse ist nicht nur die Anzahl der gebremsten Stöße, sondern sind auch die Amplitudenmaxima dieser Stöße. An Rohrleitungen in Kraftwerken z. B. sind die dynamischen Belastungen von stochastischer Art. Daher ist es unmöglich vorherzusagen, an welchen Rohrabschnitten die Stoßbremsen stark belastet werden. Die Überwachung der Funktionsfähigkeit der Stoßbremsen erfolgte deshalb bisher visuell. Dazu waren Begehungen auch des kontaminierten Bereiches von Kernkraftwerken notwendig.

Aus der DE-AS 1 082 939 ist ein Mehrkanal-Impulsamplitudenanalysator bekannt. Dieser sieht vor, daß ein Signal mit mehreren Amplitudenschwellwerten verglichen wird. Für jeden erreichten Schwellwert wird ein Signal erzeugt. Dazu dienen Diskriminatoren.

Das Ausgangssignal eines Diskriminators wird dreimal umgewandelt, und zwar durch eine erste Formgebungsleitung, durch eine Kippanordnung und durch eine zweite Formgebungsleitung. Dann erst stehen Signale zur Verfügung, die paarweise Koinzidenzkreisen zugeleitet werden können, um zu bestimmen, welches der höchste vom Eingangssignal überschrittene Amplitudenschwellwert ist. Für jeden Schwellwertbereich existiert ein Zähler, der alle Signale zählt, für die dieser Schwellwertbereich der höchste ist.

Zum Sortieren der Eingangssignale ist beim Bekannten eine aufwendige Elektronik, die neben Diskriminatoren, zwei Serien von Formgebungsleitungen, Kippanordnungen und Antikoinzidenzkreise benötigt, erforderlich.

Der Erfindung liegt die Aufgabe zugrunde, eine elektrische Schaltung aufzubauen, die die Ausgangssignale der aus der DE-OS 34 29 805 bekannten Kraftmeßbolzen so aufarbeitet, daß nicht nur die Zahl der mechanischen Stöße zu registrieren ist, sondern auch die bei den einzelnen Stößen auf die Stoßbremse einwirkende Kraft festgestellt wird. Erst durch eine Zuordnung der einwirkenden Kraft auf die einzelnen Stöße wird es möglich, die Belastung der Stoßbremsen so genau zu messen, daß daraus auf die Funktionsfähigkeit und sogar auf die noch verbleibende Lebensdauer jeder einzelnen Stoßbremse zu schließen ist. Dadurch sollen Begehungen und visuelle Inspektionen entbehrlich sein.

Die Schaltung soll mit möglichst wenigen elektronischen Bauteilen auskommen und trotzdem zuverlässig arbeiten. Dabei soll sichergestellt sein, daß nur Maxima der Amplitude gezählt werden.

Die Aufgabe wird gemäß der Erfindung dadurch gelöst, daß der Anschlußpunkt über einen Eingangsgleichrichter mit den positiven Eingängen mehrerer als Diskriminatoren dienenden Komparatoren verbunden ist, an deren negativen Eingängen in der Reihenfolge vom ersten zum letzten Komparator jeweils niedrigere konstante Potentiale anliegen,

daß der Ausgang eines jeden Komparators mit dem ersten Eingang eines Ex-Oder-Gliedes verbunden ist, am zweiten Eingang des ersten Ex-Oder-Gliedes, das mit dem ersten Komparator am ersten Eingang verbunden ist, ein Null-Signal ständig anliegt und mit dem zweiten Eingang jedes weiteren Ex-Oder-Gliedes der Ausgang desjenigen Komparators verbunden ist, der in der Reihenfolge vor dem mit dem ersten Eingang verbundenen Komparator angeordnet ist,

daß die Ausgänge der Ex-Oder-Glieder mit den ersten Eingängen von Und-Gliedern verbunden sind, mit deren zweiten Eingängen ein Abgriff hinter dem Eingangsgleichrichter über ein Differenzierglied und einen Schwellwertkomparator in Verbindung steht und

daß die Ausgänge der Und-Glieder mit Zählern verbunden sind.

Durch den Einsatz eines Differenziergliedes und eines Schwellwertkomparators zum Bestimmen des Maximums des Eingangs. signales wird in Verbindung mit den Und-Gliedern gemäß der Erfindung der Vorteil erzielt, daß als Diskriminatoren einfache Komparatoren ausreichen, die darüber hinaus durch keine weiteren elektronischen Bauteile ergänzt werden müssen. Die Ausgänge der Komparatoren können vorteilhafterweise direkt mit den Ex-Oder-Gliedern in Verbindung stehen.

Mit der Einrichtung gemäß der Erfindung wird der Vorteil erzielt, daß mit einfachen Bauteilen stets gewährleistet ist, daß nur Maxima des Eingangssignals gezählt werden. Es werden zum Beispiel keine Spitzen des Eingangssignals gezählt.

Zur Funktions- und Lebensdauerüberwachung einer Stoßbremse wird deren Ausgangssignal durch die Komparatoren gleichzeitig mit mehreren verschieden hohen und konstanten Potentialen vergliehen. Zuvor wird das Signal gleichgerichtet, da positive wie negative Amplituden gleich zu bewerten sind. Sie tragen beide in gleichem Maße zur Belastung der Stoßbremse bei. Am Ausgang eines Komparators steht ein Signal an, falls die Amplitude des vom Kraftmeßbolzen ausgehenden Signales größer ist als das Potential am negativen Eingang.

Folglich ist durch die Signale an den Ausgängen der Komparatoren, an deren negativen Eingängen verschieden hohe konstante Potentiale anliegen zu erkennen, welche untere Schwelle von der Amplitude des Meßsignales überschritten ist. Damit durch eine zusätzliche obere Schwelle der Bereich, in dem die gemessene Amplitude liegt, möglichst eng einzugrenzen ist, sind den Komparatoren Ex-Oder-Glieder nachgeschaltet. Ex-Oder-Glieder geben am Ausgang dann ein Signal ab, wenn nur an einem der beiden Eingänge ein Signal ansteht. Falls an beiden Eingängen ein Signal ansteht oder falls an beiden Eingängen ein Signal nicht ansteht, ist ein Ausgangssignal nicht zu erwarten. Die Ex-Oder-Glieder sind so angeordnet, daß sie stets den Ausgang eines Komparators mit dem Ausgang des vorangestellten Komparators vergleichen. Ist ein vorangestellter Komparator nicht vorhanden, dann ist an dem freibleibenden Eingang dieses Ex-Oder-Gliedes ständig ein Nullsignal angelegt.

Mit dieser Schaltungsanordnung wird der Vorteil erzielt, daß stets nur an einem der Ex-Oder-Glieder ein Ausgangssignal abzunehmen ist. Dieses Signal zeigt an, daß die Amplitude des Meßwertes in der Spanne zwischen denjenigen Potentialen liegt, die an den negativen Eingängen der beiden mit dem Ex-Oder-Glied verbundenen Komparatoren anliegen. Ein Ausgangssignal an einem Ex-Oder-Glied zeigt also ein Meßsignal an mit einer Amplitude, die in einer genau definierten Spanne liegt.

Damit stets nur Amplitudenmaxima der Meßsignale registriert werden, sind den Ex-Oder-Gliedern Und-Glieder nachgeschaltet. Den zweiten Eingängen dieser Und-Glieder wird das gleichgerichtete Meßsignal über ein Differenzierglied und einen Schwellwertkomparator zugeführt. Falls das differenzierte Meßsignal eine festzulegende sehr kleine Schwelle unterschreitet, liegt ein Extremwert des Meßsignales vor. Nur in diesem Fall wird bedingt durch die Und-Glieder ein Ausgangssignal von einem der Ex-Oder-Glieder zu einem Zähler durchgeschaltet. Zähler sind mit den Ausgängen der Und-Glieder verbunden.

Mit der Erfindung wird der Vorteil erzielt, daß für jeden wählbaren Amplitudenbereich der Meßsignale ein eigener Zähler vorhanden ist. Es wird also nicht nur angezeigt, wie viele Impulse ein Kraftmeßbolzen aufnimmt. Vielmehr werden die Meßsignale nach ihrer Impulshöhe in Gruppen eingeteilt und durch getrennte Zähler angezeigt, wie viele Impulse in jeder Gruppe gemessen wurden. Da die Belastung beispielsweise einer Stoßbremse und damit deren verbleibende Lebensdauer außer von der Anzahl der gebremsten Stöße auch von der Impulshöhe dieser Stöße abhängt, ist durch die erfindungsgemäße Einrichtung erstmals eine automatisierte Überwachung der Stoßbremsen durchführbar. Inspektionsgänge sind nicht mehr erforderlich. Daher ist die erfindungsgemäße Einrichtung besonders gut zur Überwachung von Stoßbremsen an Rohrleitungen in Kernkraftwerken einsetzbar.

Die erfindungsgemäße Einrichtung ist aber auch zu verwenden, um beliebige andere Meßsignale hinsichtlich ihrer Amplitudenmaxima zu sortieren und zu registrieren.

Die negativen Eingänge der Komparatoren sind beispielsweise mit Abgriffen einer Spannungsteilerschaltung verbunden. Man erhält durch die Wahl der ohmschen Widerstände in der Spannungsteilerschaltung an den Abgriffen eine ansteigende Reihe verschiedener konstanter Potentiale.

Vor dem Differenzierglied, das den zweiten Eingängen der Und-Glieder vorgeschaltet ist, ist beispielsweise ein Tiefpaß angeordnet. Damit werden hochfrequente Störungen ausgefiltert.

Hinter Differenzierglied und Schwellwertkomparator ist beispielsweise ein Impulsgeber angeordnet. Ein Ausgangssignal am Schwellwertkomparator löst dann einen definierten Impuls aus, der den Und-Gliedern zugeführt wird. Dadurch wird gewährleistet, daß an den zweiten Eingängen der Und-Glieder im Falle eines Amplitudenmaximums des Meßsignales stets ein ideal geformter Eingangsimpuls anliegt.

Mit der Erfindung wird der Vorteil erzielt, daß an den Zählern zuverlässig die bisherige Belastung einer Stoßbremse aus der Verteilung der Impulszahlen auf verschiedene Amplitudenbereiche abzulesen ist. Dieses Spektrum der Amplitudenmaxima gibt auch Aufschluß darüber, ob die Stoßbremse noch funktionsfähig ist, d.h. ob sie den Anforderungen genügt. Darüber hinaus ist aus dem Spektrum die noch zu erwartende Lebensdauer einer Stoßbremse ablesbar.

Mit der erfindungsgemäßen Einrichtung ist erstmals eine automatisierte Überwachung der Stoßbremsen durchführbar, die Begehungen überflüssig macht. Die erfindungsgemäße Einrichtung ist besonders vorteilhaft im kontaminierten Bereich von Kernkraftwerken einsetzbar.

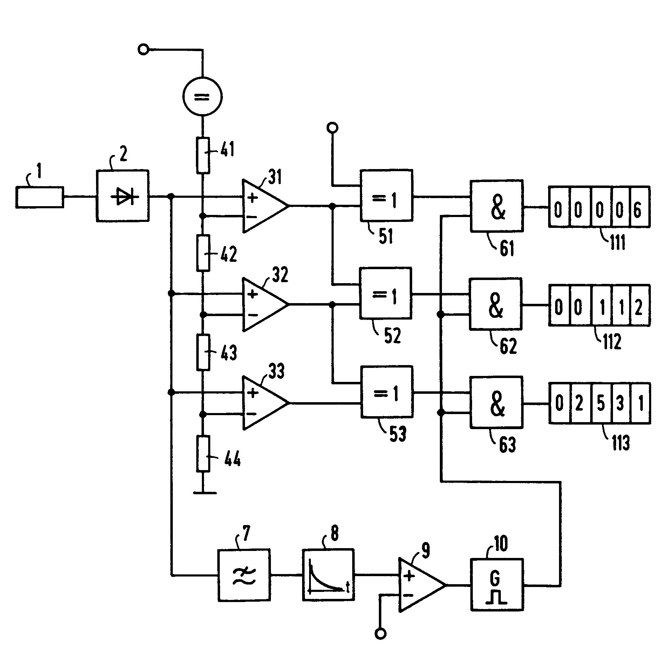

Die Erfindung wird anhand der Zeichnung näher erläutert:

Die Zeichnung zeigt ein Schaltbild der erfindungsgemäßen Einrichtung zum selektiven Zählen von Signalen.

Zur Funktions- und Lebensdauerüberwachung einer Stoßbremse werden Meßsignale eines mit der Stoßbremse verbundenen Kraftmeßbolzens 1 hinsichtlich ihrer Amplitudenmaxima selektiert und gezählt. Dazu ist der Ausgang des Kraftmeßbolzens 1 über einen Gleichrichter 2 mit den positiven Eingängen von Komparatoren 31, 32 und 33 verbunden. Die negativen Eingänge der Komparatoren 31, 32 und 33 sind mit Abgriffen einer Spannungsteilerschaltung verbunden, die aus einer Serienschaltung von ohmschen Widerständen 41 bis 44 an einer Gleichspannungsquelle besteht. An der Spannungsteilerschaltung liegen beispielsweise 10 Volt an. Den Ausgängen der Komparatoren 31, 32 und 33 sind Ex-Oder-Glieder 51, 52 und 53 zugeordnet. Dabei steht der Ausgang jedes Komparators 31, 32 und 33 mit dem ersten Eingang des zugeordneten Ex-Oder Gliedes 51, 52 und 53 und mit dem zweiten Eingang des dem nächsten Komparator 32, 33 zugeordneten Ex-Oder-Gliedes 52, 53 in Verbindung. Der zweite Eingang des Ex-Oder-Gliedes 51, das dem ersten Komparator 31 zugeordnet ist, ist ständig mit einem Null-Signal belegt. Nur jeweils am Ausgang eines der Ex-Oder-Glieder 51, 52 und 53 kann ein Eins-Signal anliegen, was bedeutet, daß das Amplitudenmaximum des Meßsignales in einem der durch die Spannungsteilerschaltung festgelegten Intervalle liegt. Die Ausgänge der Ex-Oder-Glieder 51, 52 und 53 stehen mit ersten Eingängen von Und-Gliedern 61, 62 und 63 in Verbindung. An den zweiten Eingängen dieser Und-Glieder 61, 62 und 63 liegt dann ein Impuls an, falls das Amplitudenmaximum des Meßsignales erreicht ist. Dazu ist ein Abgriff hinter dem Gleichrichter 2 über eine Serienschaltung aus Tiefpaß 7, Differenzierglied 8, Schwellwertkomparator 9 und Impulsgeber 10 mit den zweiten Eingängen der Und-Glieder 61, 62 und 63 verbunden. Am Ausgang eines der Und-Glieder 61, 62 und 63 steht also nur dann ein Signal an, falls das Amplitudenmaximum des Meßsignales des Kraftmeßbolzens 1 in einem durch die Spannungsteilerschaltung bestimmten Intervall liegt. Die Ausgänge der Und-Glieder 61, 62 und 63 sind mit Zählern 111, 112 und 113 verbunden. Dort werden die Meßsignale für jedes Amplitudenintervall getrennt gezählt. Die Zählerstände geben Aufschluß über die bisherige Belastung, die Funktionstüchtigkeit und die noch zu erwartende Lebensdauer der Stoßbremse, an der der Kraftmeßbolzen 1 angeordnet ist.

## Patentansprüche

1. Einrichtung zum selektiven Zählen von Signalen separiert nach ihrem Amplitudenmaximum, insbesondere von Signalen eines Kraftmeßbolzens (1), der mit einer Stoßbremse verbunden ist, zur Funktions- und Lebensdauerüberwachung der Stoßbremse, wobei ein Anschlußpunkt für das zu untersuchende Signal mit Diskriminatoren für verschiedene zunehmend höhere Amplitudenschwellwerte verbunden ist und wobei benachbarte Diskriminatoren jeweils mit einem Ex-Oder-Glied (51, 52, 53) in Verbindung stehen, deren Ausgänge mit Zählern (111, 112, 113) verbunen sind, **dadurch gekennzeichnet,** daß der Anschlußpunkt über einen Eingangsgleichrichter (2) mit den positiven Eingängen mehrerer als Diskriminatoren dienenden Komparatoren (31, 32 und 33) verbunden ist, an deren negativen Eingängen in der Reihenfolge vom ersten (31) zum letzten Komparator (33) jeweils niedrigere konstante Potentiale anliegen, daß der Ausgang eines jeden Komparators (31, 32 und 33) mit dem ersten Eingang eines Ex-Oder-Gliedes (51, 52 und 53) verbunden ist, am zweiten Eingang des ersten Ex-Oder-Gliedes (51), das mit dem ersten Komparator (31) am ersten Eingang verbunden ist, ein Null-Signal ständig anliegt und mit dem zweiten Eingang jedes weiteren Ex-Oder-Gliedes (52 und 53) der Ausgang desjenigen Komparators (31 und 32) verbunden ist, der in der Reihenfolge vor dem mit dem ersten Eingang verbundenen Komparator (32 und 33) angeordnet ist,
daß die Ausgänge der Ex-Oder-Glieder (51, 52 und 53) mit den ersten Eingängen von Und-Gliedern (61, 62 und 63) verbunden sind, mit deren zweiten Eingängen ein Abgriff hinter dem Eingangsgleichrichter (2) über ein Differenzierglied (8) und einen Schwellwertkomparator (9) in Verbindung steht und daß die Ausgänge der Und-Glieder (61, 62 und 63) mit Zählern (111, 112 und 113) verbunden sind.

2. Einrichtung nach Anspruch 1,
**dadurch gekennzeichnet,** daß die negativen Eingänge der Komparatoren (31, 32 und 33) mit Abgriffen einer aus Widerständen (41 bis 44) gebildeten Spannungsteilerschaltung verbunden sind.

3. Einrichtung nach Anspruch 1, **dadurch gekennzeichnet,** daß dem Differenzierglied (8) ein Tiefpaß (7) vorgeschaltet ist.

4. Einrichtung nach Anspruch 1, **dadurch gekennzeichnet,** daß dem Schwellwertkomparator (9) ein Impulsgeber (10) nachgeschaltet ist.

## Claims

1. Device for the selective counting of signals separated according to their maximum amplitude, in particular of signals from a force gauge pin (1), which is connected to a dashpot, for the monitoring of the function and service-life of the dashpot, wherein a connection point for the signal to be examined is connected to discriminators for various increasingly higher amplitude threshold values and wherein adjacent discriminators are in each case connected to an EX-OR-gate (51, 52, 53), the outputs of which are connected to counters (111, 112, 113), characterized in that the connection point is connected via an input rectifier (2) to the positive inputs of several comparators (31, 32 and 33) serving as discriminators, lower constant potentials being applied to their negative inputs in sequence from the first (31) to the last comparator (33) in each case, that the output of each comparator (31, 32 and 33) is connected to the first input of an EX-OR-gate (51, 52 and 53), a zero signal is constantly applied to the second input of the first EX-OR-gate (51), which is connected to the first comparator (31) at the first input, and the second input of each further EX-OR-gate (52 and 53) is connected with the output of that comparator (31 and 32) which is arranged in sequence before the comparator (32 and 33) connected to the first input, that the outputs of the EX-OR-gates (51, 52 and 53) are connected to the first inputs of AND-gates (61, 62 and 63), with the second inputs of which a tap behind the input rectifier (2) is connected via a differentiating element (8) and a threshold value comparator (9) and that the outputs of the AND-gates (61, 62 and 63) are connected to counters (111, 112 and 113).

2. Device according to claim 1,
characterized in that the negative inputs of the comparators (31, 32 and 33) are connected to taps from a voltage divider circuit formed from resistances (41 to 44).

3. Device according to claim 1,
characterized in that a low-pass filter (7) is connected in front of the differentiating element (8).

4. Device according to claim 1,
characterized in that a pulse generator (10) is connected after the threshold value comparator (9).

**Revendications**

1. Dispositif pour compter séparément, de façon sélective, des signaux en fonction de leur maximum d'amplitude, notamment de signaux d'une tige dynamométrique (1), qui est raccordée à un amortisseur à fluide, pour le contrôle du fonctionnement et de la durée de vie de l'amortisseur à fluide, et dans lequel un point de raccordement pour le signal devant être étudié est raccordé à des discriminateurs pour différentes valeurs de seuil d'amplitude, qui augmentent de façon croissante, et dans lequel des discriminateurs voisins sont raccordés respectivement à un circuit OU-Exclusif (51,52,53), dont les sorties sont raccordées à des compteurs (111,112,113),
caractérisé par le fait que le point de raccordement est relié, par l'intermédiaire d'un redresseur d'entrée (2), aux entrées positives de plusieurs comparateurs (31,32 et 33) qui sont utilisés comme discriminateurs et aux entrées négatives desquelles sont appliqués des potentiels respectifs constants de plus en plus faibles en partant du premier comparateur (31) jusqu'au dernier comparateur (33), que la sortie de chaque comparateur (31,32,33) est raccordée à la première entrée d'un circuit OU-Exclusif (51,52 et 53), qu'un signal nul est appliqué en permanence à la seconde entrée du premier circuit OU-Exclusif (51), dont la première entrée est raccordée au premier comparateur (31), et qu'à la seconde entrée de chaque autre circuit OU-Exclusif (52 et 53) est raccordée la sortie du comparateur (31 et 32) qui est disposé, dans la succession, en amont du comparateur (32 et 33) raccordé à la première entrée, que les sorties des circuits OU-Exclusif (51,52 et 53) sont raccordées aux premières entrées de circuits ET (61,62 et 63), aux secondes entrées desquels une prise est raccordée, en aval du redresseur d'entrée (2) par l'intermédiaire d'un circuit différentiateur (8) et d'un comparateur à valeur de seuil (9), et que les sorties des circuits ET (61,62,63) sont raccordées à des compteurs (111,112 et 113).

2. Dispositif suivant la revendication 1, caractérisé par le fait que les entrées négatives des comparateurs (31,32 et 33) sont reliées à des prises d'un circuit diviseur de tension formé par des résistances (41 à 44).

3. Dispositif suivant la revendication 1, caractérisé par le fait qu'un filtre passe-bas (7) est branché en amont du circuit différentiateur (8).

4. Dispositif suivant la revendication 1, caractérisé par le fait qu'un générateur d'impulsions (10) est branché en aval du comparateur à valeur de seuil (9).